(19) Europäisches Patentamt

European Patent Office

Office européen des brevets

(11) **EP 0 965 854 B1**

(12) **EUROPÄISCHE PATENTSCHRIFT**

(45) Veröffentlichungstag und Bekanntmachung des Hinweises auf die Patenterteilung:
**07.12.2005 Patentblatt 2005/49**

(51) Int Cl.⁷: **G01R 33/565**

(21) Anmeldenummer: **99201833.3**

(22) Anmeldetag: **09.06.1999**

(54) **Korrektur von Phasenfehlern durch begleitende Gradienten in der Magnetresonanzbildgebung**

Correction of phase errors due to concomitant gradients in MRI

Correction d'erreurs de phase causées par des gradients concomitants dans l'IRM

(84) Benannte Vertragsstaaten:
**DE FR GB NL**

(30) Priorität: **17.06.1998 DE 19826864**

(43) Veröffentlichungstag der Anmeldung:
**22.12.1999 Patentblatt 1999/51**

(73) Patentinhaber:
• **Philips Intellectual Property & Standards GmbH**
**20099 Hamburg (DE)**
Benannte Vertragsstaaten:
**DE**
• **Koninklijke Philips Electronics N.V.**
**5621 BA Eindhoven (NL)**
Benannte Vertragsstaaten:
**FR GB NL**

(72) Erfinder: **Aldefeld, Bernd Dr.**
**22335 Hamburg (DE)**

(74) Vertreter: **Volmer, Georg et al**
**Philips Intellectual Property & Standards GmbH,**
**Postfach 50 04 42**
**52088 Aachen (DE)**

(56) Entgegenhaltungen:
• **ZHOU X.J. ET AL.: "Strategies to Minimize Phase Errors Induced by Maxwell Field" PROCEEDINGS OF THE INTERNATIONAL SOCIETY FOR MAGNETIC RESONANCE IN MEDICINE, SIXTH SCIENTIFIC MEETING AND EXHIBITION, Bd. 1, 18. April 1998 (1998-04-18), Seite 571 XP002180882 Sydney, Australia**
• **ZHOU X J ET AL: "CONCOMITANT MAGNETIC-FIELD-INDUCED ARTIFACTS IN AXIAL ECHO PLANAR IMAGING" MAGNETIC RESONANCE IN MEDICINE, ACADEMIC PRESS, DULUTH, MN, US, Bd. 39, Nr. 4, 1. April 1998 (1998-04-01), Seiten 596-605, XP000740836 ISSN: 0740-3194**

**Beschreibung**

Die Erfindung betrifft ein MR-Verfahren nach dem Oberbegriff des Anspruchs 1 sowie ein MR-Gerät zur Durchführung des Verfahrens.

Aus der WO 98 02 757 (PHN 15 893) ist es bekannt, daß bei MR-Verfahren sogenannte "begleitende Gradienten" auftreten; unter "begleitenden Gradienten" (concomitant gradients) versteht man die Gradienten der Magnetfelder, die zur Richtung des stationären Magnetfeldes senkrecht stehen. Sie entstehen zwangsläufig zusammen mit den erwünschten Gradienten der in Richtung des stationären Feldes verlaufenden Magnetfeld-Komponente als Konsequenz der Maxwellschen Gleichungen. Diese begleitenden Gradienten können Abbildungsfehler zur Folge haben, wenn Schichten untersucht werden, deren Ebenen nicht senkrecht zur Richtung des homogenen stationären Magnetfeldes verlaufen (koronale, sagittale oder schräge Schichten) oder wenn die Schichten außerhalb des Isozentrums eines MR-Gerätes liegen.

Die Beeinträchtigung der Bildqualität durch die begleitenden Gradienten hängt von deren Größe in bezug auf das stationäre Magnetfeld ab. Bei großen stationären Magnetfeldern (0,5 Tesla oder mehr) ist in der Regel der Einfluß der begleitenden Gradienten auf die Bildqualität kaum erkennbar. Bei niedriger Stärke des stationären Magnetfeldes jedoch - z.B. 15 mT, wie sie bei den sogenannten Overhauser-Abbildungsverfahren auftreten - ist ihr negativer Einfluß auf die Bildqualität sehr ausgeprägt.

Zur Kompensation der durch die begleitenden Gradienten verursachten, die Bildqualität beeinträchtigenden Phasenfehler werden bei dem bekannten MR-Gerät fünf zusätzliche Spulen verwendet, mit denen Korrekturmagnetfelder erzeugt werden. Die Ansteuerung der Zusatzspulen erfolgt mit Pulsen, die der jeweiligen MR-Pulssequenz angepaßt werden müssen. Diese Lösung bedingt einen relativ großen Aufwand.

Eine andere, aus Proc. SMRM, London 1985, 1037-1038 bekannte Lösung sieht die Aufspaltung des Präphasierungspulses für den Lesegradienten und des Phasenkodierungsimpulses in je zwei Teile vor, zwischen denen ein 180° Hochfrequenzimpuls auf den Untersuchungsbereich einwirkt. Die Phasenfehler sind dann zum Zeitpunkt, wenn der Lesegradient gestartet wird, gleich Null. Ein Nachteil dieser Methode ist die Notwendigkeit, bei jeder Sequenz einen 180° Hochfrequenzimpuls verwenden zu müssen.

Ähnlich sind einige der in Proc. ISMRM, Vol 1, 1998, p. 571 zur Minimierung von Phasenfehlern beschriebenen Strategien. Diesen Strategien ist gemeinsam, daß vor und nach einem 180°-Hochfrequenzimpuls Gradientenfelder geschaltet werden, deren zeitlicher Verlauf in einer bestimmten Beziehung zueinander steht. Bei einer dieser Strategien wird auf der einen Seite des 180°-Hochfrequenzimpulses ein bipolarer Impuls eines Gradientenfeldes geschaltet, dessen zeitliches Integral Null ist, wobei zusätzlich das zeitliche Integral über das Quadrat dieses Gradientenfeldes die gleiche Größe hat wie das zeitliche Integral über das Quadrat des Gradientenfeldes auf der anderen Seite des 180°-Hochfrequenzimpulses.

Aufgabe der vorliegenden Erfindung ist es, den Einfluß der begleitenden Gradienten auf die Bildqualität mit geringem Aufwand und ohne die Zuhilfenahme von zusätzlichen 180° Hochfrequenzimpulsen zu verringern. Eine erste Lösung dieser Aufgabe ist in Anspruch 1 und eine zweite Lösung ist in Anspruch 2 angegeben.

Die beiden Lösungen basieren auf der Überlegung, daß das aus den MR-Signalen erzeugte MR-Bild Unschärfen (blurring) aufweist, wenn das Gradientenfeld - und damit der Phasenfehler - im Untersuchungsbereich im Zeitintervall zwischen der Anregung der Kernmagnetisierung und dem Empfang der MR-Signale in den einzelnen Sequenzen (als Sequenz wird hierbei und im folgenden die einmalige Anregung der Kernmagnetisierung und der nachfolgende Empfang eines MR-Signals bezeichnet) als Folge der für die Bildgebung erforderlichen Ortskodierung eine sich von Sequenz zu Sequenz ändernde Größe hat. Wenn nun die im Zeitintervall auf den Untersuchungsbereich einwirkenden Gradientenfelder die im Anspruch 1 oder 2 angegebenen Bedingungen erfüllen, so daß die Verteilung des Phasenfehlers für alle Sequenzen zumindest näherungsweise gleich groß ist, bedeutet dies, daß das aus den dabei empfangenen MR-Signalen rekonstruierte MR-Bild keine Unschärfen mehr aufweist.

Bei den Lösungen nach den Ansprüchen 1 und 2 wird die Tatsache ausgenutzt, daß die Phasenkodierung linear von dem zeitlichen Integral über den Phasenkodierungs-Gradienten abhängt, während der Phasenfehler vom zeitlichen Integral des Quadrats des Gradienten abhängt. Der zeitliche Verlauf der Gradienten läßt sich also so gestalten, daß einerseits die erforderliche Phasenkodierung erzielt wird, andererseits der Phasenfehler für alle Sequenzen die gleiche Größe hat.

Die beiden Lösungen sehen die Verwendung eines bipolaren Impulses des Gradienten vor. Als bipolarer Impuls dieses Gradienten wird dabei ein Gradient bezeichnet, der (während des Zeitintervalls) seine Polarität von einem positiven auf einen negativen Wert ändert. Bipolare Impulse von Gradienten sind an sich bekannt, z.B. aus der DE-PS 40 04 185. Bei dem bekannten Verfahren dienen die bipolaren Gradientimpulse jedoch der Flußkompensation. Die störenden Effekte der begleitenden Gradienten können mit der bekannten Impulssequenz nicht korrigiert werden, u.a. weil sie bei allen Sequenzen denselben zeitlichen Verlauf haben.

Durch die im Anschluß an das genannte Zeitintervall - d.h. während des Empfangs des MR-Signals - wirksamen begleitenden Gradienten kann sich der Phasenfehler zwar erneut zeitlich ändern, jedoch für alle MR-Signale in gleicher Weise. Dadurch werden lediglich Verzerrungen in dem MR-Bild hervorgerufen. Während die Unschärfe nachträglich (d.h. bei oder nach der Rekonstruktion) nicht mehr beseitigt werden kann, kann - bei Bedarf - die Verzerrung des MR-Bildes nachträglich gemäß Anspruch 3 korrigiert werden.

Gemäß Anspruch 4 ist es von Vorteil, wenn der Phasenkodierungsgradient und der Lesegradient sich während des Zeitintervalls nicht überlappen.

Ein MR-Gerät zur Durchführung des erfindungsgemäßen Verfahrens ist in Anspruch 5 bzw. 6 angegeben.

Die Erfindung wird nachstehend anhand der Zeichnungen näher erläutert. Es zeigen:

Fig. 1    Ein MR-Gerät mit dem die Erfindung ausführbar ist.

Fig. 2    Das Blockschaltbild eines derartigen MR-Gerätes.

Fig. 3    Den zeitlichen Verlauf verschiedener Signale bei einer ersten Sequenz und

Fig. 4    eine Modifikation dieser Sequenz.

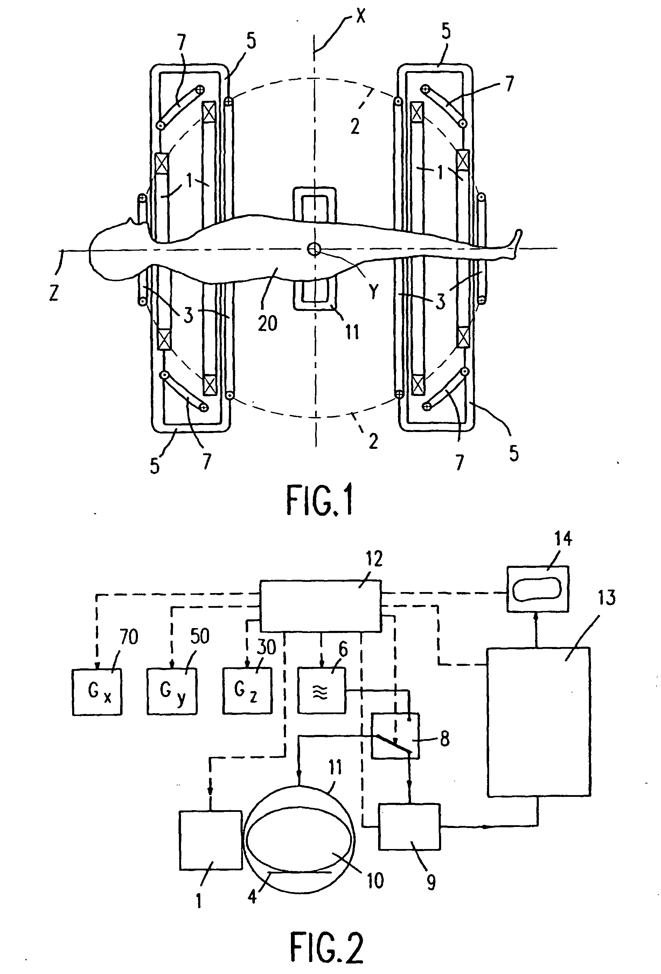

Das in Fig. 1 schematisch dargestellte MR-Gerät besitzt einen aus z.B. vier Spulen bestehenden Hauptfeldmagneten 1, der ein in z-Richtung verlaufendes, homogenes stationäres Magnetfeld erzeugt, dessen Stärke ggf einstellbar sein kann. Im Innern des Hauptfeldmagneten 1 befindet sich der zu untersuchende Patient 20.

Zur Erzeugung eines in z-Richtung verlaufenden und sich in dieser Richtung linear ändernden Magnetfeldes mit dem Gradienten $G_z$ sind vier Spulen 3 vorgesehen. Weiterhin sind vier Spulen 7 vorgesehen, die ein ebenfalls in z-Richtung verlaufendes Magnetfeld mit dem Gradienten $G_x$ erzeugen, das sich linear in x-Richtung (d.h. vertikal in Fig.1) ändert. Ein in z-Richtung verlaufendes Magnetfeld mit dem Gradienten $G_y$, das sich linear in y-Richtung (senkrecht zur Zeichenebene der Fig. 1) ändert, wird von den vier Spulen 5 erzeugt, die einen identischen Aufbau haben können wie die Spulen 7. Sie sind diesen gegenüber um 90° versetzt angeordnet, und es sind nur zwei von ihnen dargestellt. (Die von den Gradientenspulen erzeugten Magnetfelder werden in dem vorliegenden Text auch vereinfacht als "Gradient" oder entsprechend ihrer Funktion als Lesegradient, Phasenkodierungsgradient oder Schichtselektionsgradient bezeichnet.) Da jede der drei Spulenanordnungen 3,5 und 7 symmetrisch zu einem Isozentrum angeordnet ist, ist die magnetische Induktion in diesem Isozentrum nur durch das stationäre homogene Magnetfeld des Hauptfeldmagneten 1 bestimmt.

Weiterhin ist eine Hochfrequenzspule 11 vorgesehen, die ein im wesentlichen homogenes und senkrecht zur Richtung des stationären Magnetfeldes (d.h. senkrecht zur z-Richtung) verlaufendes hochfrequentes Magnetfeld erzeugt. Wie in Fig. 2 dargestellt, ist die Hochfrequenzspule 11 über einen Umschalter 8 wahlweise mit einem Sender 6 oder einem Empfänger 9 verbunden. Die Hochfrequenzspule kann in der dargestellten Stellung des Umschalters zum Empfang der im Untersuchungsbereich erzeugten MR-Signale eingesetzt werden. Vorzugsweise wird zum Empfang der MR-Signale jedoch eine (oder mehrere) gesonderte, in Fig. 1 nicht näher dargestellte Hochfrequenzempfangsspule verwendet. Im Empfänger 9 werden die MR-Signale phasenempfindlich detektiert und digitalisiert.

Die zeitliche Lage der Hochfrequenzimpulse, ihre Bandbreite und ihre Mittenfrequenz sind von einer Steuereinheit 12 steuerbar, die auf den Sender 6 einwirkt. Die Ströme der Gradientenspulen 3, 5 und 7 werden von den Einheiten 30, 50 und 70 geliefert, die ihrerseits durch die Steuereinheit 12 gesteuert werden, so daß auch der zeitliche Verlauf der Gradienten durch die Steuereinheit bestimmt wird. Außerdem ist eine Rekonstruktionseinheit 13 vorgesehen, die die in den Niederfrequenzbereich umgesetzten digitalisierten MR-Signale verarbeitet und daraus - ggf. nach einer Entzerrungsprozedur - ein MR-Bild rekonstruiert, das auf einem Monitor 14 wiedergegeben werden kann.

Bei den üblichen MR-Verfahren wird davon ausgegangen, daß der Absolutbetrag der magnetischen Flußdichte im wesentlichen durch die z-Komponente $B_z$ des Magnetfeldes bestimmt wird. Diese z-Komponente berechnet sich in bekannter Weise nach der Formel

$$B_z = B_0 + xG_x + yG_y + zG_z \tag{1}$$

Dabei ist $B_0$ die magnetische Flußdichte des stationären Magnetfeldes, x,y,z die Ortskoordinaten und $G_x$,$G_y$, $G_z$ die Gradienten des Magnetfeldes in x,y und z-Richtung. Hierbei sind die begleitenden Gradienten, die auch eine Komponente $B_x$,$B_y$ in x- bzw. y-Richtung hervorrufen jedoch vernachlässigt. Der genaue Betrag der magnetischen Flußdichte B errechnet sich demgemäß zu

$$B = \sqrt{B_x^2 + B_y^2 + B_z^2} \tag{2}$$

Die Komponenten $B_x$,$B_y$ des Magnetfeldes in x- bzw. y-Richtung berechnen sich zu

$$B_x = zG_x - \frac{x}{2}G_z \qquad\qquad (3)$$

$$B_y = zG_y - \frac{y}{2}G_z$$

Bei den üblichen MR-Verfahren, die nur Gleichung 1 berücksichtigen, wird daher die Präzession der Kernspins nicht exakt ermittelt. Es entsteht somit ein zeit- und ortsabhängiger Fehler $\Delta\Phi$ in der Berechnung der Phasenwinkel der präzedierenden Kernspins, der sich zu

$$\Delta\Phi(x,y,z,t) = \gamma\int_0^t [\sqrt{B_x^2(x,y,z,t') + B_y^2(x,y,z,t') + B_z^2(x,y,z,t')} - B_z(x,y,z,t')]dt' \qquad (4)$$

ergibt. Dabei ist $\gamma$ die gyromagnetische Konstante (ca. 42,5 MHz/T). Die Komponenten $B_x(x,y,z,t')....B_z(x,y,z,t')$ sind gegeben durch Gleichung 1 bzw. 3. Dieser Ausdruck kann in einer Taylor -Reihe entwickelt werden. Der Hauptterm der Entwicklung, d.h. der Phasenfehler erster Ordnung kann daraus wie folgt abgeleitet werden

$$\Delta\Phi_1(x,y,z,t) = g(x,y,z)\int_0^t G^2(t')dt' \qquad\qquad (5)$$

Dabei ist g (x,y,z) eine Funktion des Ortes x,y,z. G bezeichnet einen aus den Komponenten $G_x, G_y$ und $G_z$ zusammengesetzten Gradienten, zB den Phasenkodiergradienten. Die Funktion g(x,y,z) ist proportional zu $1/B_0$.

Die rekonstruierten MR-Bilder sind aufgrund der Phasenfehler je nach verwendeter MR-Methode in ihrer Qualität beeinträchtigt, was sich in Artefakten, Verzerrungen und Unschärfe äußern kann. Im Bereich der konventionellen MR, also bei mittleren und hohen stationären magnetischen Feldstärken macht sich der negative Einfluß dieser Phasenfehler nur bei einigen dafür empfindlichen MR-Methoden bemerkbar (z.B. EPI oder Spiral-MRI). Bei sehr niedrigen stationären Feldstärken insbesondere bei den sogenannten Overhauser-Abbildungsverfahren sind auch Standardmethoden betroffen. Die zeit- bzw sequenz- abhängige Variation des Phasenfehlers und die dadurch hervorgerufene Unschärfe des MR-Bildes wird dadurch vermieden, daß die MR-Sequenz, die an sich bekannt sein kann, so modifiziert wird, daß $\Delta\Phi_1$ (x,y,z,t) für alle Sequenzen gleich groß wird.

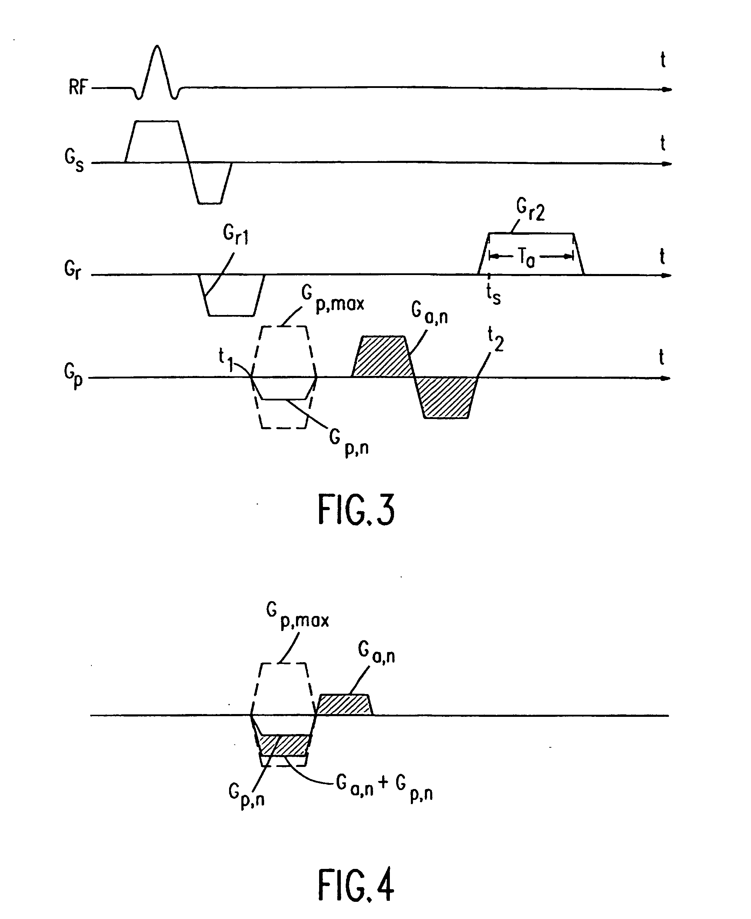

Fig. 3 zeigt die erfindungsgemäße Modifikation einer Sequenz vom 2DFT-Typ, bei der der sogenannte k-Raum linienweise abgetastet wird (bei jeder Sequenz, bzw. bei jedem Phasenkodierschritt wird eine Linie des k-Raums abgetastet). Die erste und die zweite Zeile zeigen den zeitlichen Verlauf des Hochfrequenzimpulses RF und des Schichtselektionsgradienten $G_s$. Durch die dargestellte zeitliche Lage von RF und $G_s$ wird die Kernmagnetisierung in einer zur Richtung des Schichtselektionsgradienten $G_s$ senkrechten Schicht angeregt. In der dritten Zeile ist der zeitliche Verlauf des Lesegradienten $G_r$ dargestellt. Dem eigentlichen Lesegradienten $G_{r2}$ geht ein Präphasierungsgradient $G_{r1}$ voraus. $G_{r1}$ und $G_{r2}$ haben einander entgegengesetzte Polaritäten, und das zeitliche Integral über $G_{r1}$ ist i.a. halb so groß wie das zeitliche Integral über $G_{r2}$.

In dem Zeitintervall $t_1$-$t_2$ zwischen dem Ende von $G_{r1}$ und dem Beginn von $G_{r2}$ wird zunächst in an sich bekannter Weise ein Phasenkodiergradient $G_{p,n}$ erzeugt (der Index n besagt, daß es sich um die n-te Sequenz handelt), dessen Amplitude bzw. zeitliches Integral von Sequenz zu Sequenz geändert wird, wobei der maximale positive bzw. negative Phasenkodiergradient $G_{p,max}$ gestrichelt dargestellt ist. Erfindungsgemäß wird anschließend ein bipolarer Gradientenpuls $G_{a,n}$ - mit derselben Richtung wie der Phasenkodierungsgradient erzeugt, der zur Zeit $t_2$ (oder davor) beendet ist. Der bipolare Impuls hat nacheinander eine positive und eine negative Polarität (oder umgekehrt) und ist so bemessen, daß das zeitliche Integral über $G_{a,n}$ Null ist. $G_{a,n}$ hat also keinerlei Einfluß auf die Phasenkodierung.

Der durch die von Sequenz zu Sequenz geänderten Gradienten $G_{p,n}$ und $G_{a,n}$ erzeugte Phasenfehler $\Delta\Phi_1$ errechnet sich bei dem in Figur 3 dargestellten Verlauf gemäß Gleichung 5 zu

$$\Delta\Phi_1(x, y, z, t) = g(x, y, z) \int_0^t [G_{p,n}^2(t') + G_{a,n}^2(t')]\, dt'$$

(6)

Die Amplituden von $G_{p,n}$ und $G_{a,n}$ werden nun z.B. so gewählt, daß die Gleichung

$$G_{a,n} = \sqrt{\frac{1}{2}(G_{p,max}^2 - G_{p,n}^2)}$$

(7)

erfüllt ist (in diesem Fall bezeichnen $G_{p,n}$ und $G_{a,n}$ die Amplituden). Gleichung 7 bedeutet, daß beispielsweise in einer Sequenz, in der $G_{p,n}$ den Maximalwert $G_{p,max}$ erreicht, die Amplitude von $G_{a,n}$ den Wert Null hat, während sie für $G_{p,n}$ = 0 ihren Maximalwert (ca. 0,7 $G_{p,max}$) annimmt.

Setzt man Gleichung 7 in Gleichung 6 ein, dann ergibt sich für den Phasenfehler 1.Ordnung

$$\Delta\Phi_1(x, y, z, t) = g(x, y, z, t) \int_0^t G_{p,max}^2(t')\, dt'$$

(8)

Der Phasenfehler $\Delta\Phi_1$ ist also für alle Phasenkodierschritte (bzw. alle Sequenzen) zum Zeitpunkt $t_2$ gleich groß (aber eine Funktion des Ortes). Wenn sich $G_p$ und $G_r$ nicht überlappen - was vorteilhaft ist - sind die gesamten Phasenfehler zum Zeitpunkt $t_2$, d.h. wenn die Abtastung des MR-Signals (durch $G_{r2}$) beginnt, für alle Phasenkodierschritte gleich groß. Die bis zum Zeitpunkt der Datenabtastung akkumulierten Phasenfehler verursachen in diesem Fall nur eine Phasenmodulation des rekonstruierten MR-Bildes, die berechnet und in einfacher Weise mittels Multiplikation korrigiert werden kann. Die verbleibenden Phasenfehler, die während der Abtastung durch den Lesegradienten $G_r$ entstehen, führen zu einer räumlichen Bildverzerrung, die durch geeignete Verfahren beseitigbar ist.

Die Form des bipolaren Pulses, seine Pulslänge und seine Startzeit können von einem Phasenkodierschritt zum nächsten verändert werden. Die beiden Teile des bipolaren Impulses können unterschiedliche Form, Pulslänge und Startzeit haben. Der bipolare Impuls kann, wie in Figur 3 gestellt, nach dem Phasenkodierungsimpuls erzeugt werden, aber auch davor. Der positive und der negative Teil des bipolaren Impulses $G_{a,n}$ können auch voneinander getrennt und der eine vor und der andere Teil nach dem Phasenkodierungsimpuls erzeugt werden. Es ist aber auch möglich, daß sich der Phasenkodierungsimpuls und der bipolare Impuls überlappen, wie in Figur 4 dargestellt.

In diesem Fall kann die Amplitude des bipolaren Gradienten z.B. zu

$$G_{a,n} = -\frac{1}{2}G_{p,n} \pm \sqrt{\frac{1}{2}(G_{p,max}^2 - G_{p,n}^2)}$$

(9)

gewählt werden, wobei die positive Wurzel für positive Werte von $G_{p,n}$ zu nehmen ist und umgekehrt. In diesem Fall gilt für den Phasenfehler erster Ordnung wiederum Gleichung 8.

Nach der Rekonstruktion des MR-Bildes aus den empfangenen MR-Signalen auf übliche Weise wird das MR-Bild wie folgt entzerrt:

1. Es wird der Phasenfehler $\Delta\Phi(u,v)$, der während der Datenabtastzeit $T_a$ (siehe Fig. 3) akkumuliert wird, für jeden Bildpunkt u,v berechnet (u,v können mit den Richtungen r,p der Gradienten $G_r$ und $G_p$ identisch sein).

2. Aus dem Phasenfehler wird eine Funktion f zu

$$f(u, v) = \Delta\Phi(u, v)\frac{d}{2\pi}$$

(10)

berechnet, wobei d die lineare Abmessung eines Bildpunktes bedeutet. Anschließend wird die Funktion f nach der Raumkoordinate u differenziert (df/du).

3. Das korrigierte MR-Bild I(u,v) wird aus dem unkorrigierten MR-Bild $I_0(u,v)$ dann für jeden Bildpunkt nach der Formel

$$I(u,v) = I_0(u+f,v)(1+\,^{df}/_{du})e^{jf\pi/d} \tag{11}$$

abgeleitet $(j=(-1)^{1/2})$.

Das erfindungsgemäße Verfahren kann bei verschiedenen MR-Sequenzen angewandt werden. Die Ausführungsbeispiele zeigen die Kombination mit einer Gradientenecho-Sequenz. In ähnlicher Weise ist eine Kombination mit einer Spinechosequenz möglich. Das Verfahren kann auch in einer segmentierten EPI-Sequenz verwendet werden, um einen Teil der Phasenfehler, nämlich die durch die unterschiedlichen Präphasierungsimpulse entstehenden zu kompensieren.

Wenn die Richtungen von $G_p$ und $G_r$ in der x-y-Ebene liegen, kann man die Variation des Phasenkodier-Gradienten auch dadurch kompensieren, daß man den bipolaren Gradienten in Richtung des Lesegradienten verlaufen läßt. Es ist also nicht erforderlich, den Phasenkodierungs-Gradienten durch einen bipolaren Gradientenimpuls zu modifizieren, wie in Verbindung mit den Figuren 3 und 4 erläutert. Es können auch die anderen Gradienten $G_r$, $G_s$ von Sequenz zu Sequenz geändert werden. Wesentlich ist dabei nur, daß der Phasenfehler für alle Sequenzen für jedes Voxel gleich groß ist (für verschiedene Voxel kann der Phasenfehler aber unterschiedlich sein).

## Patentansprüche

**1.**   MR-Verfahren mit einer mehrfach wiederholten Puls-Sequenz, bei der in Anwesenheit eines homogenen, stationären Magnetfeldes die Kernmagnetisierung in einem Untersuchungsbereich angeregt wird, wonach ein MR-Signal aus dem Untersuchungsbereich empfangen wird, wobei in dem Zeitintervall zwischen der Anregung der Kernmagnetisierung und dem Empfang des MR-Signals ein Phasenkodiergradient mit von Sequenz zu Sequenz geändertem zeitlichen Integral erzeugt wird,

<u>gekennzeichnet durch</u> die zusätzliche Erzeugung eines bipolaren Impulses ($G_a$) des Gradienten-Magnetfeldes innerhalb des Zeitintervalls, wobei der bipolare Impuls vor oder nach dem Phasenkodiergradienten erzeugt wird, oder der positive und der negative Teil des bipolaren Impulses getrennt sind und ein Teil vor und der andere Teil nach dem Phasenkodiergradienten erzeugt wird, wobei in jedem Fall das zeitliche Integral über den bipolaren Impuls Null ist und das zeitliche Integral über die Summe der Quadrate des Phasenkodiergradienten und des bipolaren Impulses für alle Sequenzen gleich ist, so daß die räumliche Verteilung des Phasenfehlers für alle Sequenzen - zumindest näherungsweise - gleich groß ist.

**2.**   MR-Verfahren mit einer mehrfach wiederholten Puls-Sequenz, bei der in Anwesenheit eines homogenen, stationären Magnetfeldes die Kernmagnetisierung in einem Untersuchungsbereich angeregt wird, wonach ein MR-Signal aus dem Untersuchungsbereich empfangen wird, wobei in dem Zeitintervall zwischen der Anregung der Kernmagnetisierung und dem Empfang des MR-Signals ein Phasenkodiergradient mit von Sequenz zu Sequenz geändertem zeitlichen Integral erzeugt wird,

<u>gekennzeichnet dadurch,</u> **daß** der Phasenkodiergradient die Form eines bipolaren Impulses hat, dessen zeitlicher Verlauf so gewählt ist,

- daß das zeitliche Integral über den bipolaren Impuls des Gradientenfeldes der für die betreffende Sequenz erforderlichen Phasenkodierung entspricht und
- daß das zeitliche Integral über das Quadrat des bipolaren Impulses des Gradientenfeldes für alle Sequenzen gleich groß ist, so daß die räumliche Verteilung des Phasenfehlers für alle Sequenzen - zumindest näherungsweise - gleich groß ist

**3.**   MR-Verfahren nach Anspruch 1 oder 2,
<u>gekennzeichnet durch</u> die Anwendung eines Entzerrungsverfahrens auf das aus den MR-Signalen der verschiedenen Sequenzen rekonstruierte MR-Bild zur Beseitigung der **durch** die in dem Zeitintervall wirksamen Gradienten hervorgerufenen Verzerrungen.

**4.**   MR-Verfahren nach Anspruch 1 oder 2,
<u>dadurch gekennzeichnet,</u> **daß** die Gradienten in Phasenkodier-Richtung und in Lese-Richtung sich zeitlich nicht überlappen.

5. MR-Gerät zur Durchführung des Verfahrens nach Anspruch 1, mit

a) einem Hauptfeldmagneten (1) zur Erzeugung eines homogenen stationären Magnetfeldes,
b) Gradienten-Spulenanordnungen (3,5,7) zur Erzeugung von magnetischen Gradientenfeldern mit in unterschiedlichen Richtungen verlaufenden Gradienten
c) einer Hochfrequenzspulenanordnung (11) zum Anregen der Kernmagnetisierung in einer Schicht eines Untersuchungsbereiches durch wenigstens einen Hochfrequenzimpuls (RF),
d) einem Empfänger (9) zum Erfassen der im Untersuchungsbereich erzeugten MR-Signale,
e) einer Steuereinheit (12) zur Steuerung der Ströme durch die Gradientenspulenanordnung (3,5,7) und durch die Hochfrequenzspulenanordnung (11)

**dadurch gekennzeichnet, daß** die Steuereinheit (12) so programmiert ist, daß innerhalb des Zeitintervalls zwischen der Anregung der Kernmagnetisierung und dem Empfang des MR-Signals zusätzlich zu einem Phasenkodiergradienten ein bipolarer Impuls ($G_a$) des Gradienten-Magnetfeldes vor oder nach dem Phasenkodiergradienten erzeugt wird, oder der positive und der negative Teil des bipolaren Impulses getrennt sind und ein Teil vor und der andere Teil nach dem Phasenkodiergradienten erzeugt wird, wobei in jedem Fall das zeitliche Integral über den bipolaren Impuls Null ist und das zeitliche Integral über die Summe der Quadrate des Phasenkodiergradienten und des bipolaren Impulses für alle Sequenzen gleich ist, so daß die räumliche Verteilung des Phasenfehlers für alle Sequenzen - zumindest näherungsweise - gleich groß ist.

6. MR-Gerät zur Durchführung des Verfahrens nach Anspruch 2, mit

a) einem Hauptfeldmagneten (1) zur Erzeugung eines homogenen stationären Magnetfeldes,
b) Gradienten-Spulenanordnungen (3,5,7) zur Erzeugung von magnetischen Gradientenfeldern mit in unterschiedlichen Richtungen verlaufenden Gradienten
c) einer Hochfrequenzspulenanordnung (11) zum Anregen der Kernmagnetisierung in einer Schicht eines Untersuchungsbereiches durch wenigstens einen Hochfrequenzimpuls (RF),
d) einem Empfänger (9) zum Erfassen der im Untersuchungsbereich erzeugten MR-Signale,
e) einer Steuereinheit (12) zur Steuerung der Ströme durch die Gradientenspulenanordnung (3,5,7) und durch die Hochfrequenzspulenanordnung (11) **dadurch gekennzeichnet, daß** die Steuereinheit (12) so programmiert ist, daß innerhalb des Zeitintervalls zwischen der Anregung der Kernmagnetisierung und dem Empfang des MR-Signals ein von Sequenz zu Sequenz geänderter Phasenkodiergradient in Form eines bipolaren Impulses erzeugt wird, dessen zeitlicher Verlauf so gewählt ist,

- daß das zeitliche Integral über den bipolaren Impuls des Gradientenfeldes der für die betreffende Sequenz erforderlichen Phasenkodierung entspricht und
- daß das zeitliche Integral über das Quadrat des bipolaren Impulses des Gradientenfeldes für alle Sequenzen gleich groß ist, so daß die räumliche Verteilung des Phasenfehlers für alle Sequenzen - zumindest näherungsweise - gleich groß ist.

## Claims

1. An MR method with a pulse sequence that is repeated several times and in which the nuclear magnetization in an examination zone is excited in the presence of a uniform, steady magnetic field, after which an MR signal from the examination zone is received and a phase encoding gradient having a time integral that has been changed from one sequence to the next is generated in the time interval between the excitation of the nuclear magnetization and the reception of the MR signal, **characterized by** the additional generation of a bipolar pulse ($G_a$) of the gradient magnetic field within the time interval, while the bipolar pulse is generated before or after the phase encoding gradient, or the positive and the negative part of the bipolar pulse are separated and one part is generated before and the other part is generated after the phase encoding gradient while in each case the time integral over the bipolar pulse is zero and the time integral over the sum of the squares of the phase encoding gradient and of the bipolar pulse for all sequences is the same, so that the spatial distribution of the phase error is - at least approximately - the same for all sequences.

2. An MR method having a pulse sequence that is repeated several times, in which method the nuclear magnetization in an examination zone is excited in the presence of a uniform steady magnetic field, after which an MR signal from the examination zone is received, and a phase encoding gradient having a time integral that has been changed from one sequence to the next is generated in the time interval between the excitation of the nuclear magnetization and the reception of the MR signal, **characterized in that** the phase encoding gradient has the shape of a bipolar pulse whose time pattern has been chosen such that:

- the time integral over the bipolar pulse of the gradient field corresponds to the phase encoding necessary for the relevant sequence and
- the time integral over the square of the bipolar pulse of the gradient field is equally large for all sequences, so that the spatial distribution of the phase error for all sequences is - at least approximately - equally large.

3. An MR method as claimed in Claim 1 or 2, **characterized by** the use of an equalization method on the MR image reconstructed from the MR signals of the various sequences to eliminate the distortions caused by the gradients effective during the time interval

4. An MR method as claimed in Claim 1 or 2, **characterized in that** the gradients in the phase encoding direction and in the read-out direction do not overlap in time.

5. An MR apparatus for implementing the method as claimed in Claim 1, comprising

a) a main field magnet (1) for generating a uniform, steady magnetic field,
b) gradient coil systems (3, 5, 7) for generating magnetic gradient fields having gradients extending in different directions,
c) an RF coil system (11) for exciting the nuclear magnetization in a slice of an examination zone by means of at least one RF pulse (RF),
d) a receiver (9) for receiving the MR signals generated in the examination zone,
e) a control unit (12) for controlling the currents through the gradient coil system (3, 5, 7) and the RF coil system (11), **characterized in that** the control unit (12) is programmed in such a manner that in the time interval between the excitation of the nuclear magnetization and the reception of the MR signal, in addition to a phase encoding gradient, a bipolar pulse ($G_a$) of the gradient magnetic field is generated before or after the phase encoding gradient, or the positive and the negative part of the bipolar pulse are separated and one part is generated before and the other part is generated after the phase encoding gradient, while in each case the time integral over the bipolar pulse is zero and the time integral over the sum of the squares of the phase encoding gradient and the bipolar pulse is the same for all sequences so that the spatial distribution of the phase error is - at least substantially - equally large for all sequences.

6. An MR apparatus for implementing the method as claimed in Claim 2, comprising

a) a main field magnet (1) for generating a uniform, steady magnetic field,
b) gradient coil systems (3, 5, 7) for generating magnetic gradient fields having gradients extending in different directions,
c) an RF coil system (11) for exciting the nuclear magnetization in a slice of an examination zone by means of at least one RF pulse (RF),
d) a receiver (9) for receiving the MR signals generated in the examination zone,
e) a control unit (12) for controlling the currents through the gradient coil system (3, 5, 7) and the RF coil system (11), **characterized in that** the control unit (12) is programmed in such a manner that in the time interval between the excitation of the nuclear magnetization and the reception of the MR signal a phase encoding gradient which is modified from one sequence to the next is generated in the form of a bipolar pulse whose time variation is chosen such that

- the time integral over the bipolar pulse of the gradient field corresponds to the phase encoding necessary for the relevant sequence and
- the time integral over the square of the bipolar pulse of the gradient field is equally large for all sequences, so that the spatial distribution of the phase error for all sequences is - at least approximately - equally large.

**EP 0 965 854 B1**

**Revendications**

1. Procédé RM avec une séquence d'impulsions répétée à plusieurs reprises, dans lequel, en présence d'un champ magnétique stationnaire homogène, la magnétisation nucléaire est excitée dans une zone à examiner, après quoi un signal RM est reçu à partir de la zone à examiner, auquel cas, dans l'intervalle temporel entre l'excitation de la magnétisation nucléaire et la réception du signal RM, au moins un gradient de codage de phase est produit avec une intégrale temporelle modifiée d'une séquence à l'autre,
**caractérisé par** la production supplémentaire d'une impulsion bipolaire ($G_a$) du champ magnétique à gradient dans l'intervalle temporel, l'impulsion bipolaire étant produite avant ou après le gradient de codage de phase ou les parties positive et négative de l'impulsion bipolaire étant séparées et une partie étant produite avant et l'autre partie après le gradient de codage de phase, auquel cas l'intégrale temporelle est en tout cas zéro sur l'impulsion bipolaire et l'intégrale temporelle sur la somme des carrés du gradient de codage de phase et de l'impulsion bipolaire étant égale pour toutes les séquences de telle sorte que la distribution spatiale de l'erreur de phase soit de même grandeur pour toutes les séquences - du moins approximativement.

2. Procédé RM avec une séquence d'impulsions répétée à plusieurs reprises, dans lequel, en présence d'un champ magnétique stationnaire homogène, la magnétisation nucléaire est excitée dans une zone à examiner, après quoi un signal RM est reçu à partir de la zone à examiner, auquel cas, dans l'intervalle temporel entre l'excitation de la magnétisation nucléaire et la réception du signal RM, au moins un gradient de codage de phase est produit avec une intégrale temporelle modifiée d'une séquence à l'autre,
**caractérisé en ce que** le gradient de codage de phase a la forme d'une impulsion bipolaire dont le tracé temporel est choisi de telle sorte que:

- l'intégrale temporelle sur l'impulsion bipolaire du champ à gradient corresponde au codage de phase nécessaire pour la séquence correspondante et
- l'intégrale temporelle sur le carré de l'impulsion bipolaire du champ à gradient soit d'égale grandeur pour toutes les séquences de telle sorte que la distribution spatiale de l'erreur de phase soit d'égale grandeur pour toutes les séquences - du moins approximativement.

3. Procédé RM selon l'une des revendications 1 ou 2,
**caractérisé par** l'application d'un procédé de redressement à l'image RM reconstruite à partir des signaux RM des différentes séquences pour l'élimination des distorsions provoquées par les gradients actifs dans l'intervalle temporel.

4. Procédé RM selon l'une des revendications 1 ou 2,
**caractérisé en ce que** les gradients dans la direction de codage de phase et dans la direction de lecture ne se chevauchent pas temporellement.

5. Appareil RM pour l'exécution du procédé selon la revendication 1, avec

a) un aimant de champ principal (1) pour la production d'un champ magnétique stationnaire homogène,
b) des agencements de bobines à gradient (3, 5, 7) pour la production de champs à gradient magnétiques avec des gradients s'étendant dans différentes directions;
c) un agencement de bobines à haute fréquence (11) pour l'excitation de la magnétisation nucléaire dans une couche d'une zone à examiner par au moins une impulsion à haute fréquence (RF);
d) un récepteur (9) pour la saisie des signaux RM produits dans la zone à examiner,
e) une unité de commande (12) pour la commande des courants par les agencements de bobines à gradient (3, 5, 7) et par l'agencement de bobines à haute fréquence (11),
**caractérisé en ce que** l'unité de commande (12) est programmée de telle sorte que, dans l'intervalle temporel entre l'excitation de la magnétisation nucléaire et la réception du signal RM, une impulsion bipolaire ($G_a$) du champ magnétique à gradient soit produite avant ou après le gradient de codage de phase en plus d'un gradient de codage de phase ou les parties positive et négative de l'impulsion bipolaire sont séparées et une partie est produite avant et l'autre partie après le gradient de codage de phase, auquel cas l'intégrale temporelle est en tout cas zéro sur l'impulsion bipolaire et l'intégrale temporelle sur la somme des carrés du gradient de codage de phase et de l'impulsion bipolaire étant égale pour toutes les séquences de telle sorte que la distribution spatiale de l'erreur de phase soit de même grandeur pour toutes les séquences - du moins approximativement.

6. Appareil RM pour l'exécution du procédé selon la revendication 2, avec

f) un aimant de champ principal (1) pour la production d'un champ magnétique stationnaire homogène,
g) des agencements de bobines à gradient (3, 5, 7) pour la production de champs à gradient magnétiques avec des gradients s'étendant dans différentes directions;
h) un agencement de bobines à haute fréquence (11) pour l'excitation de la magnétisation nucléaire dans une couche d'une zone à examiner par au moins une impulsion à haute fréquence (RF);
i) un récepteur (9) pour la saisie des signaux RM produits dans la zone à examiner,
j) une unité de commande (12) pour la commande des courants par les agencements de bobines à gradient (3, 5, 7) et par l'agencement de bobines à haute fréquence (11),

**caractérisé en ce que** l'unité de commande (12) est programmée de telle sorte que, dans l'intervalle temporel entre l'excitation de la magnétisation nucléaire et la réception du signal RM, un gradient de codage de phase variant d'une séquence à l'autre est produit sous la forme d'une impulsion bipolaire dont le tracé temporel est choisi de telle sorte que:

- l'intégrale temporelle sur l'impulsion bipolaire du champ à gradient corresponde au codage de phase nécessaire pour la séquence correspondante et
- l'intégrale temporelle sur le carré de l'impulsion bipolaire du champ à gradient soit d'égale grandeur pour toutes les séquences de telle sorte que la distribution spatiale de l'erreur de phase soit d'égale grandeur pour toutes les séquences - du moins approximativement.

EP 0 965 854 B1

FIG.1

FIG.2

11

FIG. 3

FIG. 4